# EUROPÄISCHE PATENTANMELDUNG

(11) **EP 1 608 026 A2**
(43) Veröffentlichungstag der Anmeldung: **21.12.2005**
(21) Anmeldenummer: 05090173.5
(22) Anmeldetag: 10.06.2005
(51) Int. Cl.: H01L 31/0203, G02B 6/42

(54) **Optoelektronische Vorrichtung und Verfahren zur Herstellung einer optoelektronischen Vorrichtung**

(30) Priorität: 18.06.2004 US 871315
(71) Anmelder: Infineon Technologies Fiber Optics GmbH, 13629 Berlin (DE)
(72) Erfinder: Schunk, Nikolaus, 93142 Maxhütte-Haidhof (DE)
(74) Vertreter: Müller, Wolfram Hubertus

(57) **Zusammenfassung**

Die vorliegende Erfindung betrifft eine optoelektronische Vorrichtung, die mindestens ein optoelektronisches Wandlerbauelement, ein Leadframe, auf dem das Wandlerbauelement angeordnet ist, ein Gehäuse, das das Wandlerbauelement zumindest teilweise umgibt, und ein Drahtgeflecht aufweist. Dabei ist das Drahtgeflecht zumindest teilweise in das Gehäuse eingebettet und mit mindestens einem Masse-Kontakt des Leadframes unter Ausbildung eines Schirmkäfigs, in dem sich das Wandlerbauelement befindet, verbunden. Hierdurch wird eine einfache und preiswerte Schirmung gegenüber elektromagnetischer Störstrahlung bereitgestellt. Die Erfindung betrifft des weiteren zwei Herstellungsverfahren zur Herstellung einer solchen Vorrichtung.

## Beschreibung

Bezeichnung der Erfindung: Optoelektronische Vorrichtung mit einem Schirmkäfig und Verfahren zur Herstellung einer optoelektronischen Vorrichtung mit einem Schirmkäfig.

Die Erfindung betrifft eine optoelektronische Vorrichtung, in die ein Schirmkäfig zur Reduzierung elektromagnetischer Störstrahlung integriert ist. Die Erfindung betrifft des Weiteren zwei Verfahren zur Herstellung einer derartigen optoelektronischen Vorrichtung mit integriertem Schirmkäfig.

### Hintergrund der Erfindung

Es besteht allgemein das Problem, optische Transceiver bzw. deren Wandlermodule elektromagnetisch abzuschirmen. So muss das Sendebauelement eines optischen Transceivers aufgrund seiner elektromagnetischen Abstrahlung abgeschirmt werden. Das Empfangselement eines optischen Transceivers muss gegen elektromagnetische Einstrahlung geschützt werden, um den Einfluss von Störstrahlung auf die Signaldetektion zu minimieren.

Es ist bekannt, zur elektromagnetischen Schirmung ein äußeres Schirmblech einzusetzen, das vollständig um die jeweilige optische Komponente gebogen wird. Des Weiteren ist es zur Reduzierung elektromagnetischer Störstrahlung bekannt, die Module in einen Spritzgusskörper einzustecken, wobei der Spritzgusskörper aus einer leitenden Spritzgussmasse besteht.

Die bekannten technischen Lösungen sind aufwändig und kostenintensiv. Auch wird durch die Verwendung eines äußeren Schirmblechs zusätzlicher Platz benötigt, so dass der Abstand zwischen dem Sendemodul und dem Empfangsmodul in einem optischen Transceiver nicht in gewünschtem Maße reduziert werden kann, was zu unerwünschten Designeinschränkungen führt.

Es besteht somit ein Bedürfnis, in einfacher und effektiver Weise eine Schirmung optoelektronischer Wandler in optischen Transceivern bereitzustellen.

### Zusammenfassung der Erfindung

Die vorliegende Erfindung stellt eine optoelektronische Vorrichtung zur Verfügung, die folgende mindestens ein optoelektronisches Wandlerbauelement, ein Leadframe, auf dem das Wandlerbauelement angeordnet ist, ein Gehäuse, das das Wandlerbauelement zumindest teilweise umgibt, und ein Drahtgeflecht aufweist. Dabei ist das Drahtgeflecht zumindest teilweise in das Gehäuse eingebettet und
mit mindestens einem Masse-Kontakt des Leadframes unter Ausbildung eines Schirmkäfigs, in dem sich das Wandlerbauelement befindet, verbunden.

Der Erfindung liegt der Gedanke zu Grunde, einen Schutz gegen elektromagnetische Störstrahlung mittels eines Drahtgeflechts zur Verfügung zu stellen, das in die jeweilige optoelektronische Vorrichtung bzw. das jeweilige optoelektronsche Modul integriert ist. Durch die Integration des Drahtgeflechtes in die optoelektronische Vorrichtung wird eine preiswerte und platzsparende Lösung bereitgestellt.

Das Drahtgeflecht ist erfindungsgemäß zumindest teilweise in das Gehäuse eingebettet und bildet zusammen mit dem Leadframe einen Schirmkäfig aus. Der Schirmkäfig kann dabei in unmittelbarer Angrenzung an das Wandlerbauelement ausgebildet werden. Die elektromagnetische Einstrahlung bzw. Abstrahlung kann dadurch in sehr effektiver Weise reduziert werden.

Durch die Wahl eines Drahtgeflechtes zur Ausbildung eines Schirmkäfigs weist der Schirmkäfig eine nur geringe Kapazität auf, so dass eine kapazitive Rückwirkung des Drahtgeflechtes auf die Eigenschaften der internen Schaltung der optoelektronischen Vorrichtung vernachlässigbar ist. Dies stellt einen weiteren Vorteil der Erfindung dar.

In einer bevorzugten Ausgestaltung der Erfindung weist das Drahtgeflecht lediglich im Bereich des optischen Pfades bzw. des optischen Fensters des Wandlerbauelementes eine Öffnung auf. Im Bereich dieser Öffnung weist das Gehäuse der optoelektronischen Vorrichtung bevorzugt eine optische Funktionsfläche, z.B. eine Linse auf. Es verbleibt damit lediglich eine kleine ungeschirmte Öffnung im Bereich des optischen Fensters: eine Öffnung im Drahtgeflecht ist auf einen äußerst kleinen Bereich reduziert.

Der Durchmesser bzw. die Drahtstärke des Drahtes des Drahtgeflechts ist bevorzugt derart gewählt, dass er ein Mehrfaches der Eindringtiefe der elektromagnetischen Strahlung beträgt, die durch die Eindringtiefe des Skin-Effektes bestimmt wird. Die Eindringtiefe liegt bei elektromagnetischer Strahlung im Frequenzbereich größer 10 Mbit/s im µm-Bereich, so dass Drahtstärken größer 50 µm eine Unterdrückung der elektromagnetischen Störstrahlung um mehr als 30 dB gewährleisten.

In einer bevorzugten Ausgestaltung ist in das Drahtgeflecht an dessen Vorderfläche ein Abstandshalter integriert. Der Abstandshalter verhindert eine elektrische Verbindung des Drahtgeflechts zu den Kontaktpins des Leadframes, auch wenn diese - wie häufig üblich - im Bereich der Anbindung an eine Schaltungsplatine gebogen ausgeführt sind. Es ist dadurch möglich, die Schirmung an der Vorderseite des Drahtgeflechts bis auf den Schaltungsträger zu führen.

Die vorliegende Erfindung stellt auch zwei Verfahren zur Verfügung, mit denen eine optoelektronische Vorrichtung mit einem integrierten Schirmblech herstellbar ist.

Gemäß einem ersten Verfahren erfolgt zunächst ein Anordnen des Wandlerbauelementes auf einem Leadframe und ein elektrisches Kontaktieren des Wandlerbauelementes auf dem Leadframe in an sich bekannter Weise. Es wird ein Drahtgeflecht bereitgestellt, das derart gebogen ist, dass es eine an mindestens einer Seite offene Struktur bildet. Hierzu weist das Drahtgeflecht beispielsweise eine Vorderseite und mindestens einen im Wesentlichen senkrecht von der Vorderseite abstehenden seitlichen Bereich auf. Das Drahtgeflecht wird nun mit mindestens einem Masse-Kontakt des Leadframes verbunden, wobei eine offene Seite der Struktur des Drahtgeflechts durch das Leadframe geschlossen wird. Hierdurch entsteht ein Schirmkäfig, in dem sich der Wandlerbaustein befindet.

Das Leadframe wird nun mit nach unten hängendem Drahtgeflecht in eine Gießform eingelegt, bei der es sich bevorzugt um eine Spritzgussform handelt. Es wird ein Vergussmaterial in die Gießform eingebracht. Nach Erhärten des Vergussmaterials bildet dieses ein Gehäuse, das das Leadframe mit dem Wandlerbauelement enthält. Insbesondere ist auch das Drahtgeflecht vollständig in das Gehäuse eingebettet. Es wird auf diese Weise eine fest in das Gehäuse integrierte und das Wandlerbauelement unmittelbar umgebende Schirmungsstruktur bereitgestellt.

Dabei wird darauf hingewiesen, dass der Masse-Pin des Leadframes sich in üblicher Weise mehrfach verzweigen kann und dabei eine Vielzahl von Masse-Kontakten bereitstellt, an denen das Drahtgeflecht jeweils punktuell befestigt werden kann. Die sich verzweigende Struktur der Masse-Kontakte weist dabei bevorzugt eine ausreichende Stabilität dahingehend auf, dass bei einem Einlegen des Leadframes mit nach unten hängendem Drahtgeflecht in eine Gießform die einzelnen Masse-Kontakte nicht oder nur unwesentlich gebogen werden. Hierdurch wird die Gefahr eines unerwünschten Kontaktes des Drahtgeflechtes mit Bonddrähten des Leadframes vermieden.

In einem zweiten Verfahren wird wiederum das Wandlerbauelement auf dem Leadframe angeordnet und dort elektrisch kontaktiert. Dabei kann das Wandlerbauelement, auch in dem voran genannten Verfahren, mittels eines Trägerelementes (Submount) auf dem Leadframe angeordnet sein. Es wird dann ein eben ausgebreitetes Drahtgeflecht bereitgestellt und dieses teilweise in die Gießform eingelegt. Das Leadframe mit dem Wandlerbauelement wird ebenfalls in die Gießform eingebracht, und zwar beabstandet zu dem Drahtgeflecht. Es wird nun ein Vergussmaterial in die Gießform eingebracht und dort erhärtet. Das erhärtete Vergussmaterial bildet ein Gehäuse der Vorrichtung aus, wobei das Drahtgeflecht teilweise in das Gehäuse eingebettet ist. Nach Erhärten des Vergussmaterials werden die seitlich des Gehäuses angeordneten Bereiche des Drahtgeflechtes in Richtung des Leadframes umgebogen und mindestens ein umgebogener Bereich zumindest teilweise mit mindestens einem Masse-Kontakt des Leadframes unter Ausbildung eines Schirmkäfigs verbunden.

Bei beiden Verfahren erfolgt eine Herstellung der optoelektronischen Vorrichtung bevorzugt im Nutzen auf einem Multinest-Werkzeug, wobei nach Aushärten des Vergussmaterials die einzelnen optoelektronischen Vorrichtungen des Multinest-Werkzeugs vereinzelt werden. Insbesondere ist bei dem zweiten Verfahren bevorzugt vorgesehen, dass nach dem Gießvorgang die einzelnen Vorrichtungen des Multinest-Werkzeugs vereinzelt werden und hierbei das Drahtgeflecht im Bereich zwischen den einzelnen Vorrichtungen durchtrennt wird, wodurch seitlich des Gehäuses angeordnete Bereiche des Drahtgeflechtes zur Verfügung gestellt werden, die in Richtung des Leadframes umbiegbar sind.

### Kurze Beschreibung der Figuren

Die Erfindung wird nachfolgend anhand der Figuren anhand mehrerer Ausführungsbeispiele näher erläutert. Es zeigen:
- Figur 1a: ein Ausführungsbeispiel einer optoelektronischen Vorrichtung mit einem Sendebauelement und einem Schirmkäfig in Vorderansicht;
- Figur 1b: ein Ausführungsbeispiel einer optoelektronischen Vorrichtung mit einem Empfangsbauelement und einem Schirmkäfig in Vorderansicht;
- Figur 1c: eine Seitenansicht einer Vorrichtung gemäß Figur 1a oder Figur 1b;
- Figur 2: eine teilweise geschnittene Ansicht einer Anordnung mit einem Bodenteil einer Spritzgussvorrichtung und einem in die Spritzgussvorrichtung eingebrachten Leadframe sowie einem auf dem Leadframe angeordenten Laser-Chip;
- Figur 3: eine teilweise geschnittene Ansicht einer Anordnung mit einem Bodenteil einer Spritzgussvorrichtung und einem in die Spritzgussvorrichtung eingebrachten Leadframe und einem auf dem Leadframe angeordenten Fotodioden-Chip;
- Figur 4a: ein Leadframe mit darauf angeordneten Komponenten sowie einem Drahtgeflecht;
- Figur 4b: die Anordnung der Figur 4a in Seitenansicht und
- Figur 4c: die Anordnung der in Figur 4a in Seitenansicht, wobei das Leadframe und die auf dem Leadframe angeordneten Komponenten mit einem transparenten Vergussmaterial umhüllt sind.

### Beschreibung mehrerer bevorzugter Ausführungsbeispiele

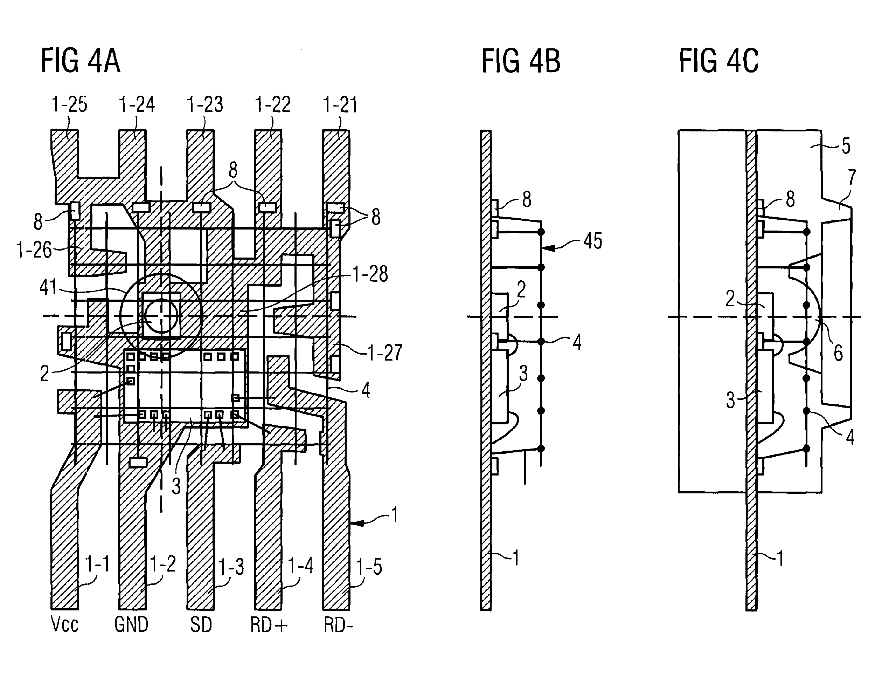

Zum besseren Verständnis der Erfindung wird zunächst anhand der Figuren 4a und 4b die Ausgangssituation beschrieben, an der die Erfindung ansetzt.

Gemäß den Figuren 4a, 4b sind auf einem Leadframe ein als Fotodioden-Chip ausgebildetes Empfangsbauelement 2 sowie ein zugeordnetes elektrisches Bauteil 3, bei dem es sich beispielsweise um einen Vorverstärker-IC handelt, angeordnet. Das Leadframe weist mehrere Pins 1-1, 1-2, 1-3, 1-4, 1-5 auf. Über den Pin 1-1 wird die Betriebsspannung V_{cc}, über den Pin 1-2 der Massekontakt, über den Pin 1-3 das Signal SD (SD = Signal detect), und über die Pins 1-4 und 1-5 das differentielle Empfangssignal RD+, RD- bereitgestellt.

Der Masse-Pin 1-2, auch als Masse-Lead 1-2 bezeichnet, verzweigt sich zu einer Auflagefläche 1-28 für die auf dem Leadframe 1 angeordneten Bauteile 2, 3 sowie zu einer Vielzahl von Masse-Armen 1-21, 1-22, 1-23, 1-24, 1-25, 1-26, 1-27.

Eine Kontaktierung des Fotodioden-Chips 2 sowie des Vorverstärker-IC's 3 erfolgt über den Masse-Lead 1-2 sowie Bonddrähte, die von den anderen Leads ausgehen.

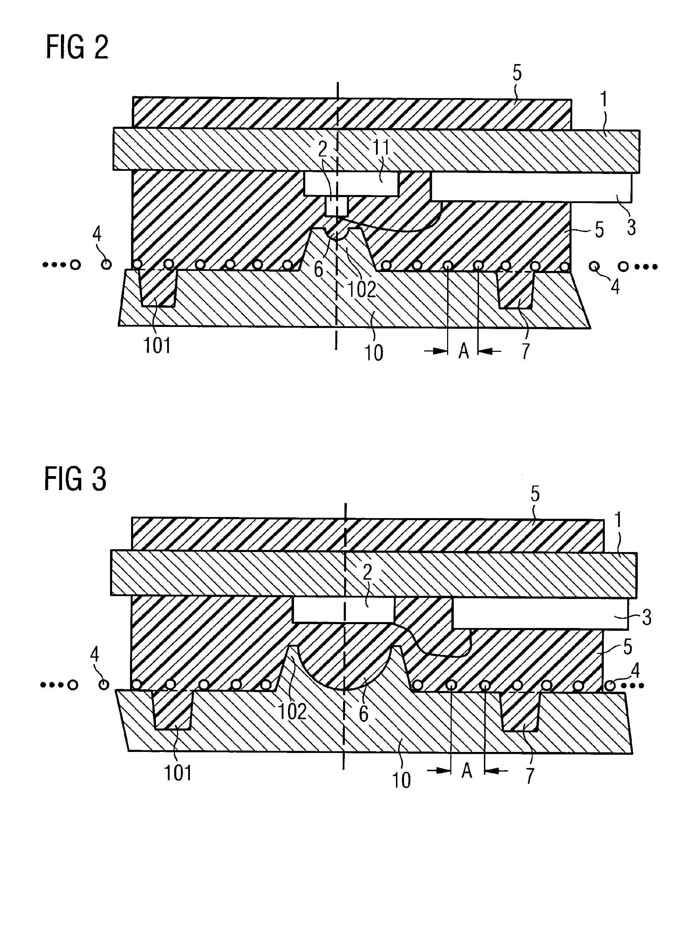

Die Ausbildung eines Sendemoduls mit einem auf dem Leadframe 1 angeordneten Laserdioden-Chip 2 erfolgt in entsprechender Weise. Einem Laserdioden-Chip 2 ist dabei als elektrisches Bauteil 3 ein Treiber-IC zugeordnet. Der Laserdioden-Chip 2 ist bevorzugt nicht unmittelbar auf dem Leadframe 1 angeordnet, sondern auf einem Trägerelement bzw. Submount 11, das wiederum mit dem Leadframe 1 verbunden ist. Eine entsprechende Anordnung ist in der Figur 2 dargestellt. Auch bei Verwendung eines Fotodioden-Chips kann dieser über einen Submount mit dem Leadframe 1 verbunden sein.

Es ist anzustreben, die von einem Laser-Chip ausgestrahlte hochfrequente elektromagnetische Strahlung bestmöglich abzuschirmen. Ebenso ist es anzustreben, einen Fotodioden-Chip möglichst effektiv gegen elektromagnetische Störstrahlung zu schützen, um die Signaldetektion frei von Störsignalen zu halten.

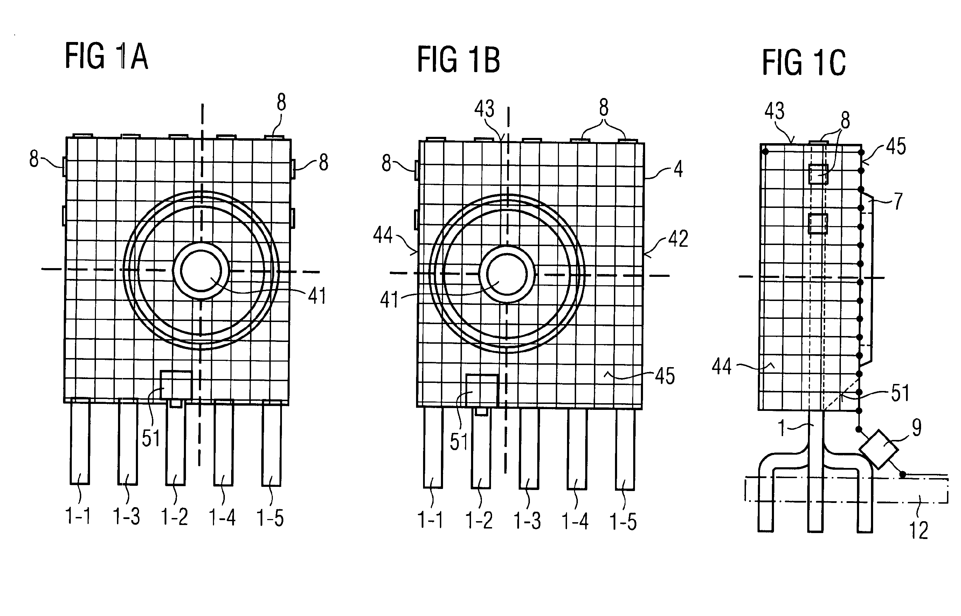

Hierzu ist vorgesehen, ein Drahtgeflecht in die Vorrichtung zu integrieren und mit dem Leadframe 1 zu verbinden, wobei Leadframe 1 und Drahtgeflecht einen Schirmkäfig ausbilden, in dem sich das optoelektronische Wandlerbauelement 2 befindet. Ein erstes Ausführungsbeispiel für eine solche Anordnung ist in den Figuren 1a bis 3 und ein zweites Ausführungsbeispiel für eine solche Anordnung in den Figuren 4a bis 4c dargestellt.

Gemäß der Anordnung der Figuren 1a bis 1c ist ein feinmaschiges Drahtgeflecht 4 vorgesehen, das derart gebogen ist, dass es eine dem Leadframe 1 beabstandete Vorderseite 45 und von der Vorderseite 45 unter einem Winkel von im Wesentlichen 90° abstehende seitliche Bereiche 42, 43, 44 aufweist. Zwei der seitlichen Bereiche sind dabei an der rechten bzw. linken Seite ausgebildet und eine der seitlichen Bereiche 43 an der Oberseite. An der Unterseite ist das Drahtgeflecht nicht in Richtung des Leadframes 1 gebogen, um einen erwünschten Kontakt mit den anderen Leads 1-1, 1-3, 1-4, 1-5 des Leadframes zu vermeiden.

Das Drahtgeflecht 4 ist an seinen seitlichen Bereichen 42, 43, 44 an Verbindungspunkten 8 mit einzelnen Masse-Armen des Masse-Leads 1-2 (entsprechend den Masse-Armen 1-21 bis 1-27 der Figur 4a) verbunden.

Es wird darauf hingewiesen, dass sich das Drahtgeflecht über das Leadframe 1 hinaus erstrecken kann, wie in Figur 1c dargestellt. Dies ist möglich, aber keineswegs notwendig. Wesentlich ist die Anbindung an die Masse-Kontakte des Leadframes, so dass Leadframe 1 und Drahtgeflecht 4 zusammen einen Schirmkäfig für das auf dem Leadframe 1 angeordnete Wandlerbauelement 2 ausbilden.

In einer bevorzugten Ausgestaltung ist vorgesehen, dass in das Drahtgeflecht der Vorderseite 45, und zwar in dem nach unten in Richtung einer Schaltungsplatine bzw. Leiterplatte 12 vorstehenden Bereich, ein nicht leitender Abstandshalter 9 integriert ist. Ein solcher Abstandshalter 9 stellt sicher, dass der nach unten vorstehende Bereich des Drahtgeflechts der Vorderseite 45 nicht in Kontakt mit den Pins 1-2, 1-3, 1-4, 1-5 des Leadframes treten kann, auch wenn diese, wie in Figur 1c dargestellt, zwecks einer stabileren Anordnung auf der zugeordneten Schaltungsplatine 12 teilweise gebogen sind.

Das Drahtgeflecht 4 ist jeweils punktuell an Befestigungspunkten 8 mit dem Leadframe 1 verbunden. Wie sich aus der Figur 1c ergibt, entsteht dabei ein im Wesentlichen geschlossener Schirmkäfig, in dem sich das Wanderbauelement 2 befindet.

Über die Vielzahl der Kontakte und Verbindungspunkte 8 des Schirmgeflechts 4 mit dem Masse-Lead 1-2 wird eine besonders gute Schirmung bereitgestellt. Darüber hinaus wird über die Vielzahl der Verbindungspunkte 8 eine sichere strukturelle Verbindung zwischen dem Drahtgeflecht 4 und dem Leadframe 1 bereitgestellt.

Wie bereits erwähnt, ist das Drahtgeflecht an möglichst vielen Seiten über möglichst viele Verbindungspunkte 8 mit dem Leadframe 1 verbunden. In der Ausgestaltung der Figur 1a erfolgt an drei Seiten eine Verbindung mit den Masse-Leads des Leadframes. In der Ausgestaltung der Figur 1b erfolgt ein solcher Kontakt an zwei Seiten. Nach unten, in Richtung der Schaltungsplatine 12 (vgl. Figur 1c), auf dem das Modul angeordnet ist, ist das Drahtgeflecht 4 wie erwähnt nicht in Richtung des Leadframes umgebogen, da ansonsten die Gefahr eines Kontaktes mit den anderen Leads 1'1, 1'3, 1'4, 1'5 des Leadframes bestehen würde. Es befindet sich an der Vorderseite aber eine Schräge 51 im Kunststoffgehäuse der Vorrichtung, die es erlaubt, auch die Vorderseite 45 des Drahtgeflechtes 4 in einem unteren Bereich mit dem Masse-Pin 1-2 zu verbinden.

Das Drahtgeflecht 4 ist im Bereich der Vorderseite 45 in das Kunststoffgehäuse eingebettet, mit dem das Leadframe 1 und die darauf angeordneten Komponenten 2, 3 umhüllt sind. Das Herstellungsverfahren wird nachfolgend anhand der Figuren 2 und 3 im Einzelnen erläutert werden.

Es sei aber zunächst noch darauf hingewiesen, dass das Drahtgeflecht 4 eine kleine Öffnung 41 in dem optischen Fenster ausbildet, über das eine Signaleinkopplung bzw. Signalauskopplung in bzw. aus dem Modul erfolgt. Die Öffnung 41 des Drahtgeflechts 4 ist aber auf ein Minimum reduziert, so dass das Abschirmverhalten durch die Öffnung 41 möglichst wenig beeinflusst wird.

Die Herstellung des Moduls gemäß der Figuren 1a bis 1c, die Ausbildung einer optischen Funktionsfläche 6 in dem Gehäuse und die Einbettung des Drahtgeflechts wird nachfolgend anhand der Figuren 2 und 3 erläutert.

Figur 2 zeigt die Herstellung einer optischen Vorrichtung mit einem Sendebauelement 2, das über ein Submount 11 auf dem Leadframe 1 angeordnet ist. Des Weiteren ist auf dem Leadframe 1 ein Treiber-IC 3 vorgesehen.

Das Leadframe 1 mit den darauf vormontierten Bauteilen 2, 3, 11 wird in eine Spritzgussvorrichtung eingebracht, von der das Bodenteil 10 dargestellt ist. Das Bodenteil weist eine kreisförmige Aussparung 101 zur Ausbildung eines Justagerings und eine vorstehende Struktur 102 zur Ausbildung einer optischen Funktionsfläche, nämlich einer Linse 6, auf.

Auf das Bodenteil 10 der Spritzgussvorrichtung wird ein noch eben ausgebildetes Drahtgeflecht 4 aufgelegt. Das Drahtgeflecht 4 ist bis auf eine Öffnung im Bereich der vorstehenden Struktur 102 des Bodenteils 10 durchgehend ausgebildet. Wie angedeutet, erstreckt sich das Drahtgeflecht 4 dabei über den Rand des Bodenteils 10 hinaus. In der Regel wird dabei vorgesehen sein, dass die Komponenten im Nutzen auf einem Multinest-Werkzeug ausgebildet werden. Es wird dann ein durchgehendes Drahtgeflecht 4 eingesetzt, das auf eine Vielzahl von Bodenteilen 10 aufgelegt wird.

In der Figur 2 ist auch die Maschenweite A des Drahtgeflechts dargestellt. Die Maschenweite liegt bevorzugt im Bereich zwischen 50 und 500 µm.

Das Oberteil der Spritzgussform ist nicht dargestellt.

Nach Einbringen und Aushärten eines in die Spritzgussvorrichtung eingebrachten transparenten Kunststoffs entsteht das transparente Gehäuse 5. Dieses bildet integriert die Funktionsfläche 6 und den Justagering 7 aus. Des Weiteren ist in das Spritzgussteil ein Teil des Drahtgeflechts 4 eingebettet und integriert.

Nach Vereinzeln der jeweiligen Module wird das seitlich überstehende Drahtgeflecht umgebogen, zur Ausbildung der seitlichen Bereiche 42, 43, 44 gemäß den Figuren 1a, 1b, 1c. Anschließend erfolgt eine Befestigung mit einzelnen Masse-Leads des Leadframs 1-2 unter Ausbildung eines elektromagnetischen Schirmkäfigs, in dem sich das Sendebauelement 2 befindet.

Der vorstehende Justagering 7 ist in der Seitendarstellung der Figur 1c zu erkennen.

Die Figur 3 zeigt ein Bodenteil 10 eines Spritzgusswerkzeugs und ein in ein solches Spritzgusswerkzeug eingebrachtes Leadframe 1 mit einem Fotodioden-Chip 2 und einem Vorverstärker-IC 3, also für den Fall einer Empfangseinrichtung. Hinsichtlich des Herstellungsverfahrens gilt das für die Figur 2 Gesagte in entsprechender Weise. Ein Unterschied besteht lediglich darin, dass zum einen der Fotodioden-Chip 2 nicht über einen Submount, sondern unmittelbar auf dem Leadframe 1 angeordnet ist. Alternativ kann aber auch eine Anordnung über einen Submount auf dem Leadframe 1 vorgesehen sein. Ein zweiter Unterschied besteht darin, dass die in den Kunststoffkörper 5 integrierte Linse 6 wesentlich größer ausgebildet ist, um einfallendes Licht optimal auf die fotoempfindliche Fläche des Fotodioden-Chips 2 zu fokussieren.

Die Figuren 4a bis 4c zeigen eine zweite Ausführungsvariante zur Herstellung eines Schirmkäfigs mit einem integrierten Drahtgeflecht.

Gemäß dieser Ausführungsvariante wird das Drahtgeflecht 4 vor Einbringen in ein Spritzgusswerkzeug und vor einem Umhüllen mit einer transparenten Spritzgussmasse mit dem Leadframe 1 verbunden. Das Drahtgeflecht wird dabei wiederum unter Bereitstellung einer Vorderseite 45 und mehrerer seitlicher Bereichen gebogen. Zum Leadframe 1 hin ist das Drahtgeflecht offen. Das Drahtgeflecht 4 wird nun an seinen seitlichen Bereichen mit den einzelnen Rahmen 1-21 bis 1-27 des Masse-Leads 1-2 an Befestigungspunkten 8 fest verbunden. Beispielsweise erfolgt ein punktuelles Löten mit den Armen des Masse-Leads. Die einzelnen Arme 1-21 bis 1-27 des Masse-Leads weisen dabei eine ausreichende Stabilität auf, um nach Befestigung des Drahtgeflechtes nicht in unerwünschter Weise durchzubiegen.

Es entsteht ein Schirmkäfig, dessen Rückseite durch das Leadframe 1 selbst gebildet wird.

Nach Anbringen des Drahtgeflechts 4 an dem Leadframe 1 werden Leadframe 1 und Drahtgeflecht 4 in eine Spritzgussvorrichtung entsprechend den Figuren 2 und 3 einbracht, wobei das Drahtgeflecht 4 nach unten hängt. Abschließend erfolgt ein Umspritzen mit transparenter Spritzgussmasse, wobei das in der Figur 4c dargestellte Kunststoffgehäuse 5 mit integrierter Linse und integriertem Justagering 7 entsteht. Bei dieser Ausgestaltung ist das Drahtgeflecht 4 vollständig in das Gehäuse 5 integriert. Anders als bei den Figuren 1a bis 1c werden somit nicht nach dem Spritzgussvorgang seitlich vorstehende Bereiche des Drahtgeflechtes 4 in Richtung des Leadframes umgebogen. Dieses ist vollständig in das Gehäuse 5 integriert.

Die Erfindung beschränkt sich in ihrer Ausgestaltung nicht auf die vorstehend dargestellten Ausführungsbeispiele. So ist es für den Fachmann offensichtlich, dass die genaue Art und Weise der Verbindung des Drahtgeflechtes mit dem Leadframe nicht wesentlich ist. Es kommt allein darauf an, dass ein Drahtgeflecht in die Vorrichtung integriert wird und dabei zusammmen mit einem Leadframe, der den Wanderbaustein trägt, einen elektromagnetischen Schirmkäfig ausbildet.

## Patentansprüche

1. Optoelektronische Vorrichtung aufweisend:
- mindestens ein optoelektronisches Wandlerbauelement (2),
- ein Leadframe (1), auf dem das Wandlerbauelement (2) angeordnet ist,
- ein Gehäuse (5), das das Wandlerbauelement (2) zumindest teilweise umgibt, und
- ein Drahtgeflecht (4), wobei
- das Drahtgeflecht (4) zumindest teilweise in das Gehäuse (5) eingebettet und
- mit mindestens einem Masse-Kontakt (1-2; 1-21 bis 1-27) des Leadframes (1) unter Ausbildung eines Schirmkäfigs, in dem sich das Wandlerbauelement (2) befindet, verbunden ist.

2. Vorrichtung nach Anspruch 1, wobei das Drahtgeflecht (4) im Bereich des optischen Fensters des Wandlerbauelementes (2) eine Öffnung (41) besitzt.

3. Vorrichtung nach Anspruch 2, wobei das Gehäuse (5) im Bereich des optischen Fensters des Wandlerbauelementes (2) eine optische Funktionsfläche (6) aufweist und die Öffnung (41) im Drahtgeflecht (4) im Bereich der optischen Funktionsfläche (6) ausgebildet ist.

4. Vorrichtung nach Anspruch 1, wobei das Drahtgeflecht (4) eine zum Leadframe (1) beabstandete Vorderseite (45) und mindestens einen zur Vorderseite (45) im Wesentlichen senkrecht sich in Richtung des Leadframes (1) erstreckenden seitlichen Bereich (42, 43, 44) ausbildet.

5. Vorrichtung nach Anspruch 4, wobei das Drahtgeflecht (4) an mindestens einem seitlichen Bereich (42, 43, 44) mit mindestens einem Masse-Kontakt (1-21 bis 1-27) des Leadframes (1) elektrisch verbunden ist.

6. Vorrichtung nach Anspruch 4, wobei die Vorderseite (45) des Drahtgeflechts (4) mit einem Masse-Kontakt (1-2) des Leadframes (1) verbunden ist und das Gehäuse (5) hierzu eine Schräge ausbildet.

7. Vorrichtung nach Anspruch 1, wobei ein nicht leitender Abstandhalter (9) an der den Kontakt-Pins des Leadframes (1) benachbarten Vorderseite (45) des Drahtgeflechts (4) in dieses integriert ist.

8. Vorrichtung nach Anspruch 1, wobei auf dem Leadframe (1) zusätzlich ein dem optoelektronischen Wandlerbauelement (2) zugeordnetes elektrisches Bauelement angeordnet ist.

9. Vorrichtung nach Anspruch 1, wobei das Wandlerbauelement (2) auf einem Trägerelement (11) angeordnet und das Trägerelement (11) auf dem Leadframe (1) angeordnet ist.

10. Vorrichtung nach Anspruch 1, wobei der Durchmesser des Drahts des Drahtsgeflechts (4) mindestens 30 µm, insbesondere mindestens 50 µm beträgt.

11. Vorrichtung nach Anspruch 1, wobei die Maschenweite des Drahtgeflechtes (4) zwischen 50 und 500 µm beträgt.

12. Vorrichtung nach Anspruch 1, wobei das Drahtgeflecht (4) aus Kupferdraht oder Aluminiumdraht besteht.

13. Vorrichtung nach Anspruch 1, wobei das mindestens eine Wandlerbauelement (2) ein Sendebauelement und/oder ein Empfangsbauelement ist.

14. Vorrichtung nach Anspruch 13, wobei die Vorrichtung einen optoelektronischen Transceiver mit einem Sendebauelement und einem Empfangsbauelement bildet.

15. Vorrichtung nach Anspruch 1, wobei das Gehäuse (5) ein aus einem Vergussmaterial bestehendes Kunststoffgehäuse ist.

16. Verfahren zur Herstellung einer optoelektronischen Vorrichtung mit einem integrierten Schirmkäfig, mit den folgenden Schritten:
- Anordnen des Wandlerbauelements (2) auf einem Leadframe (1),
- elektrisches Kontaktieren des Wandlerbauelements (2),
- Bereitstellen eines Drahtgeflechts (4), das derart gebogen ist, dass es eine an mindestens einer Seite offene Struktur bildet,
- Verbinden des Drahtgeflecht (4) mit mindestens einem Masse-Lead (1-2; 1-21 bis 1-27) des Leadframes, wobei eine offene Seite der Struktur des Drahtgeflechts (4) unter Ausbildung eines Schirmkäfigs durch das Leadframe (1) geschlossen wird,
- Einlegen des Leadframes (1) mit nach unten hängendem Drahtgeflecht (4) in eine Gießform, und
- Einbringen eines Vergussmaterials in die Gießform, wobei
- das erhärtete Vergussmaterial ein Gehäuse (5) der optoelektronische Vorrichtung ausbildet und
- das Drahtgeflecht (4) in das Gehäuse (5) eingebettet ist.

17. Verfahren nach Anspruch 16, wobei in dem Gehäuse (5) bei Einbringen des Vergussmaterials in die Gießform eine optische Funktionsfläche (6) ausgebildet wird.

18. Verfahren nach Anspruch 16, wobei das Drahtgeflecht (4) eine Öffnung (41) aufweist und das Drahtgeflecht (4) derart in der Gießform positioniert wird, dass die Öffnung (41) sich im Bereich der zu bildenden optischen Funktionsfläche (6) befindet.

19. Verfahren zur Herstellung einer optoelektronischen Vorrichtung mit einem integrierten Schirmkäfig, mit den folgenden Schritten:
- Anordnen des Wandlerbauelements (2) auf einem Leadframe (1),
- elektrisches Kontaktieren des Wandlerbauelements (2),
- Bereitstellen eines eben ausgebreiteten Drahtgeflechts (4),
- teilweises Einlegen des Drahtgeflechts (4) in die Gießform,
- Einbringen des Leadframes (1)mit dem Wandlerbauelement (2) in die Gießform beabstandet zu dem Drahtgeflecht (4),
- Einbringen eines Vergussmaterials in die Gießform, wobei das erhärtete Vergussmaterial ein Gehäuse (5) der optoelektronischen Vorrichtung ausbildet und das Drahtgeflecht (4) teilweise in das Gehäuse (5) eingebettet wird,
- nach Erhärten des Vergussmaterials Umbiegen seitlich des Gehäuses (5) angeordneter Bereiche des Drahgeflechts (4) in Richtung des Leadframe (1),
- Verbinden mindestens eines umgebogenen Bereichs des Drahtgeflechts mit mindestens einem Masse-Kontakt (1-2; 1-21 bis 1-27) des Leadframes (1) unter Ausbildung eines Schirmkäfigs.

20. Verfahren nach Anspruch 19, wobei in dem Gehäuse (5) bei Einbringen des Vergussmaterials in die Gießform eine optische Funktionsfläche (6) ausgebildet wird.

21. Verfahren nach Anspruch 20, wobei das Drahtgeflecht (5) eine Öffnung (41) aufweist und das Drahtgeflecht (4) derart in der Gießform positioniert wird, dass die Öffnung (41) sich im Bereich der zu bildenden optischen Funktionsfläche (6) befindet.

22. Verfahren nach Anspruch 19, wobei die Herstellung der Vorrichtung auf einem Multinest-Werkzeug erfolgt, nach dem Gießvorgang die einzelnen Vorrichtungen des Multinest-Werkzeugs vereinzelt werden und hierbei das Drahtgeflecht (4) im Bereich zwischen den einzelnen Vorrichtungen durchtrennt wird, wodurch seitlich des Gehäuses (5) angeordnete Bereiche (42, 43, 44) des Drahtgeflechtes (4) zur Verfügung gestellt werden, die in Richtung des Leadframes (1) biegbar sind.
